(19) Europäisches Patentamt
European Patent Office
Office européen des brevets

(11) Veröffentlichungsnummer: **0 065 285**
**B1**

(12) **EUROPÄISCHE PATENTSCHRIFT**

(45) Veröffentlichungstag der Patentschrift: **29.01.86**

(51) Int. Cl.⁴: **G 03 C 1/68**

(21) Anmeldenummer: **82104185.2**

(22) Anmeldetag: **13.05.82**

(54) **Durch Strahlung polymerisierbares Gemisch und damit hergestelltes Kopiermaterial.**

(30) Priorität: **20.05.81 DE 3120052**

(43) Veröffentlichungstag der Anmeldung: **24.11.82 Patentblatt 82/47**

(45) Bekanntmachung des Hinweises auf die Patenterteilung: **29.01.86 Patentblatt 86/5**

(84) Benannte Vertragsstaaten: **AT BE CH DE FR GB IT LI NL SE**

(56) Entgegenhaltungen:
**WO - A - 81/00626**
**DE - A - 2 614 860**
**DE - A - 3 028 136**
**US - A - 4 229 517**

(73) Patentinhaber: **HOECHST AKTIENGESELLSCHAFT, Postfach 80 03 20, D-6230 Frankfurt am Main 80 (DE)**

(72) Erfinder: **Geissler, Ulrich, Dr., Ruprechtstrasse 22, D-6000 Frankfurt/Main (DE)**
Erfinder: **Herwig, Walter, Dr., Hasenpfad 7, D-6232 Bad Soden/Ts. (DE)**
Erfinder: **Fetsch, Elisabeth, Rathenauplatz, D-6000 Wiesbaden (DE)**

**EP 0 065 285 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein durch Strahlung, insbesondere Licht, polymerisierbares Gemisch, das als wesentliche Bestandteile ein wasserunlösliches, in wässrig alkalischen Lösungen lösliches oder quellbares Bindemittel, einen Photoinitiator sowie ein Polyglykoldimethacrylat oder -diacrylat enthält.

Das Gemisch eignet sich insbesondere als Photoresist zur Herstellung von gedruckten Schaltungen, Galvano-Schablonen und geätzten Mikrostrukturen. Als weiteres Anwendungsgebiet ist die Herstellung von geätzten Tief- und Hochdruckformen zu nennen.

Negativ arbeitende Photoresistlacke, die als Lösung auf den zu bearbeitenden Schichtträger aufgebracht werden, basieren im wesentlichen auf folgenden Verbindungstypen: Polyvinylcinnamate (US-A 2 690 966, US-A 2 732 301), Polyvinylcinnamylidenester (US-A 3 549 368), Polystyrolcinnamylketon (US-A 2 566 302) und andere Cinnamoylgruppen enthaltende Polymere (DE-C 1 063 802 und 1 067 219, DE-A 2 111 415), Allylesterpräpolymere (US-A 3 376 138, US-A 3 376 139, US-A 3 462 267) sowie Polyisoprene (US-A 2 852 379, GB-A 892 811).

Obwohl einige dieser Substanzen in der Praxis als Photoresistlösungen verwendet werden, haben die meisten von ihnen bestimmte Nachteile. Sie erfordern entweder organische Lösungsmittel zur Entwicklung oder haben eine relativ geringe Lichtempfindlichkeit. Andere haben eine schlechte Haftung auf Metalloberflächen oder lassen sich nur zu relativ geringen Schichtdicken verarbeiten.

Negativ arbeitende flüssige Photoresistmassen, die auf der Vernetzung durch photoinitiierte radikalische Polymerisation beruhen und wässrig-alkalisch entwickelbar sind, werden z.B. in der DE-C 2 060 575 beschrieben. Die dort erwähnten Gemische sind jedoch empfindlich gegenüber Sauerstoff. Aus diesem Grund müssen die Schichten mit einer Polyvinylalkohol-Deckschicht versehen werden. Ein weiteres grosses Problem ist die Klebrigkeit von photopolymerisierbaren Schichten, die eine Kontaktbelichtung unmöglich machen kann. So zeigen auch die in der DE-A 2 064 079 beschriebenen Schichten Klebe- bzw. Verprägungsneigung, wenn sie im unmittelbaren Kontakt mit einer Vorlage belichtet werden.

In der DE-A 3 028 136 werden photopolymerisierbare Gemische beschrieben, die sich vorteilhaft als vorgefertigte, auf eine Kunststoffolie als temporären Schichtträger aufgebrachte übertragbare Photoresistschichten anwenden lassen. Diese Schichten werden durch Laminieren unter Druck und Erwärmen auf den endgültigen Träger übertragen. Sie enthalten zu diesem Zweck polymerisierbare Verbindungen mit höherem Molekulargewicht, nämlich Diacrylate oder Dimethacrylate von Polyglykolen, besonders Polyethylenglykolen, mit 14 bis 23 Glykoleinheiten, um ein Verdampfen des Monomeren bei der Laminiertemperatur auszuschliessen. Ein Einfluss der Art der Monomeren auf die Klebrigkeit der Schicht geht aus dem Dokument nicht hervor.

Die Anwendung derartiger Gemische als Photoresistlösungen, die als solche vom Anwender unmittelbar auf den zu bearbeitenden Schichtträger aufgebracht und getrocknet werden, hat sich bisher in der Praxis nicht durchgesetzt, da das manuelle Aufbringen von schützenden Deckschichten oder -folien auf die Photoresistschicht durch den Verbraucher zu schwierig ist.

In der DE-A 2 614 860 ist ein flüssiges, wasserlösliches Gemisch aus (A) dem Ester eins Hydroxyalkyl(meth)acrylats mit einem Maleinsäureanhydrid/Polybutadien-Addukt, (B) u.a. einem Di(meth)acrylat eines Oligoethylen- oder -propylenglykols mit 1 bis 4 Glykoleinheiten und (C) einem Benzoinether beschrieben, das zur Herstellung von Reliefdruckplatten geeignet ist. Das Problem der Klebrigkeit der unbelichteten Schicht stellt sich hier nicht, da die Schicht flüssig ist.

Aufgabe der Erfindung war es, ein durch Strahlung polymerisierbares Gemisch bereitzustellen, das sich als Trocken- und Flüssigphotoresist eignet, Schichten mit nicht klebriger Oberfläche ergibt und gegenüber Sauerstoff wenig empfindlich ist.

Gegenstand der Erfindung ist ein durch Strahlung polymerisierbares Gemisch, das als wesentliche Bestandteile

a) 20 bis 80 Gew.% eines wasserunlöslichen, in wässrig-alkalischen Lösungen löslichen Mischpolymerisats von Methylmethacrylat und Methacrylsäure oder von Methacrylsäure, Alkylmethacrylaten und Methylmethacrylat, Styrol oder Acrylnitril,

b) 0,1 bis 20 Gew.% eines durch Strahlung aktivierbaren Polymerisationsinitiators und

c) 20 bis 80 Gew.% eines Acryl- oder Methacrylsäureesters eines 2- bis 4wertigen Alkohols enthält, wobei 10 bis 100 Gew.%, bezogen auf die Gesamtmenge an polymerisierbaren Verbindungen, aus einem Polyglykoldiacrylat oder -dimethacrylat bestehen.

Das erfindungsgemässe Gemisch ist dadurch gekennzeichnet, dass das Polyglykoldimethacrylat bzw. -diacrylat eine Verbindung der Formel

$$CH_2{=}C(R){-}CO(O{-}CH_2{-}CH(CH_3))_nOOC{-}C(R){=}CH_2 \qquad (I)$$

ist, worin

R ein Wasserstoffatom oder eine Methylgruppe und

n eine Zahl von 4 bis 10 ist.

Als elektromagnetische Strahlung, gegenüber der das erfindungsgemässe Gemisch empfindlich ist, kommt jede Strahlung in Betracht, deren Energie mindestens der des kurzwelligen sichtbaren Lichts entspricht. Bevorzugt wird Licht einer Wellenlänge im Bereich von 300 bis 500 nm, es sind aber auch Röntgen-, Elektronen- und andere Korpuskularstrahlung sowie Laserstrahlung zur Auslösung der Polymerisation geeignet. In jedem Fall kann in bekannter Weise das Initiatorsystem der gewünschten Strahlung angepasst bzw. für diese sensibilisiert werden.

Von den Verbindungen der Formel I werden diejenigen besonders bevorzugt, in denen R eine Methylgruppe ist. Die Verbindungen sind als solche bekannt und im Handel erhältlich.

Ausser der polymerisierbaren Verbindung der Formel I kann das erfindungsgemässe Gemisch bis zu 90%, bezogen auf den Gesamtgehalt an polymerisierbaren Verbindungen, andere Acryl- oder Methacrylsäureester von 2 bis 4wertigen Alkoholen enthalten. Mit besonderem Vorteil werden Acryl- und insbesondere Methacrylsäureester von mehrwertigen, besonders zweiwertigen Alkoholen, die Urethangruppen im Molekül enthalten, zugesetzt. Besonders bevorzugt werden Urethanverbindungen der allgemeinen Formel II

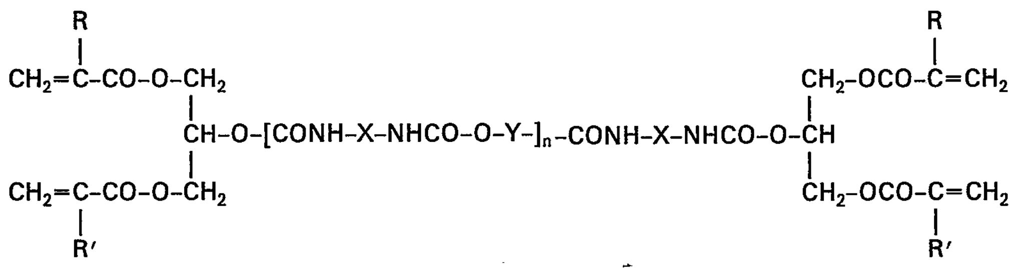
(II)

worin

X einen Kohlenwasserstoffrest, bevorzugt einen gesättigten aliphatischen oder cycloaliphatischen Rest, mit 2 bis 20 Kohlenstoffatomen,

Y eine der Gruppen

$(-C_pH_{2p}-S)_{m-1}-C_pH_{2p}-O-$,
$(-C_pH_{2p}-O)_m-$,
$-C_rH_{2r-2}-O-$,
$-C_sH_{2s}-Z(-CO-C_qH_{2q}-O)_m-$,
$(-C_qH_{2q}-O-CO-Q-COO)_m-C_qH_{2q}-O-$ und

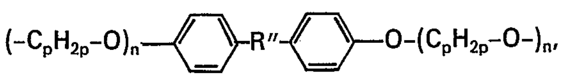

R und R′ Wasserstoffatome oder Methylgruppen,

R″ O, S, $CR_2$ oder $SO_2$,

Q eine Phenylgruppe oder eine der Gruppen $C_qH_{2q}$ und $C_qH_{2q-2}$,

Z O oder NR,

n eine Zahl von 0 bis 20,

m eine Zahl von 1 bis 40,

p eine Zahl von 2 bis 20,

q eine Zahl von 2 bis 10,

r eine Zahl von 4 bis 20 und

s eine Zahl von 2 bis 10

bedeutet.

Von den Verbindungen der Formel II werden diejenigen bevorzugt, bei denen n eine Zahl von 0 bis 20, insbesondere von 0 bis 10, ist.

R und R′ sind bevorzugt Methylgruppen.

Von den zur Herstellung der polymerisierbaren Urethane verwendeten Diolkomponenten werden die Polyetherdiole, besonders die gesättigten Vertreter, bevorzugt. Y ist also vorzugsweise die Gruppe $(-C_pH_{2p}-O)_m-$, wobei für p Werte von 2 bis 10, insbesondere von 2 bis 4, bevorzugt werden. Wenn ungesättigte Diole verwendet werden, haben diese je Dioleinheit vorzugsweise 4 bis 10 Kohlenstoffatome.

Für bestimmte Zwecke, z.B. zur Erzielung bestimmter mechanischer Eigenschaften oder höherer Lichtempfindlichkeiten, kann es auch vorteilhaft sein, Polyesterdiole zu verwenden. Diese können in bekannter Weise aus Dicarbonsäure- und Dioleinheiten oder aus Hydroxycarbonsäureeinheiten aufgebaut sein. Dabei werden als Hydroxycarbonsäuren solche mit q = 3 bis 6 bevorzugt.

Die Polyesterdiole aus Hydroxycarbonsäuren werden gewöhnlich aus Lactonen durch Ringöffnung mit einem Molekül H-aktiver Verbindung $HO-C_sH_{2s}-Z-H$ hergestellt. Hierin hat s bevorzugt einen Wert von 2 bis 6, Z ist bevorzugt ein Sauerstoffatom.

Allgemein sind Poylesterdiole mit Molekulargewichten im Bereich von etwa 500 bis 3000 gut geeignet.

Die Herstellung der polymerisierbaren Di- bzw. Polyurethane erfolgt in an sich bekannter Weise, z.B. wie es in der US-A 3 297 745, der DE-A 2 064 079 und der DE-A 2 822 190 beschrieben ist.

Man setzt zunächst zur Hestellung des Glycerindiesters 1 Mol Glycidylacrylat oder Glycidylmethacrylat mit 1 Mol Acryl- oder Methacrylsäure um. Anschliessend werden 2 Mol von diesem Reaktionsprodukt mit 1 Mol Diisocyanat umgesetzt. Das Diisocyanat ist dabei entweder monomer oder ein Reaktionsprodukt von monomerem Diisocyanat im Überschuss mit Diolkomponente. Im letzteren Falle wird zuvor die Diolkomponente HO–Y–H mit dem gewünschten Überschuss an Diisocyanat umgesetzt. Dabei werden in der Regel polymerhomologe Gemische erhalten. Die Uneinheitlichkeit der Molekulargewichte der daraus erhaltenen Diisocyanate führt zu Produkten, die hochviskos und praktisch nicht kristallisierbar sind.

Die Verbindungen der Formel II und ihre Herstellung und Anwendung sind ausführlich in der EP-A 54 700 beschrieben.

Die Gesamtmenge an polymerisierbaren Verbindungen in dem erfindungsgemässen Gemisch beträgt im allgemeinen 20 bis 80, bevorzugt 30 bis 70 Gew.%, der nichtflüchtigen Bestandteile des Gemisches.

Als Photoinitiatoren eignet sich eine Vielzahl von Substanzen, beispielsweise Benzoin, Benzoinether, Mehrkernchinone, z.B. 2-Ethylanthrachinon; Acridinderivate, z.B. 9-Phenylacridin, 9-p-Methoxyphenyl-acridin, 9-Acetylamino-acridin, Benz(a)acridin; Phenazinderivate, z.B. 9,10-Dimethyl-benz(a)phenazin, 9-Methyl-benz(a)phenazin, 10-Methoxy-benz(a)phenazin; Chinoxalinderivate, z.B. 6,4′,4″-Trimethoxy-2,3-diphenyl-chinoxalin, 4′,4″-Dimethoxy-2,3-diphenyl-5-aza-chinoxalin und Chinazolinderivate.

Die Photoinitiatoren werden im allgemeinen in einer Menge von 0,1 bis 20 Gew.%, bezogen auf die nicht flüchtigen Bestandteile des photopolymerisierbaren Gemischs, zugesetzt.

Als Bindemittel werden natürliche oder synthetische Polymere verwendet, die in Wasser unlöslich und in wässrig-alkalischen Lösungen löslich oder mindestens quellbar sind, da sich Schichten mit solchen Bindemitteln mit den bevorzugten wässrig-alkalischen Entwicklern entwickeln lassen. Derartige Bindemittel können z.B. die folgenden Gruppen enthalten: $-COOH$, $-PO_3H_2$, $-SO_3H$, $-SO_2NH_2$, $-SO_2-NH-CO-$ und dgl. Als Beispiele hierfür seien genannt: Maleinatharze, Polymerisate aus N-(p-Tolylsulfonyl)-carbaminsäure-(β-methacryloyloxy-ethyl)ester und Mischpolymerisate dieser und ähnlicher Monomerer mit anderen Monomeren, Styrol-Maleinsäureanhydrid-Mischpolymerisate, Methylmethacrylat-Methacrylsäure-Mischpolymerisate und Mischpolymerisate aus Methacrylsäure, Alkylmethacrylaten und Methylmethacrylat und/oder Styrol, Acrylnitril u.a., wie sie in den DE-A 2 064 080 und 2 363 806 beschrieben sind.

Die Menge des Bindemittels beträgt im allgemeinen 20 bis 80, vorzugsweise 30 bis 70 Gew.% der Bestandteile des Gemischs.

Das photopolymerisierbare Gemisch enthält ausser Monomeren, Bindemitteln und Photoinitiatoren noch gegebenenfalls Stabilisatoren bzw. Inhibitoren zur Verhinderung der Dunkelpolymerisation der Monomeren, Wasserstoffdonatoren, Verbindungen zur Verminderung der Sauerstoffempfindlichkeit, Netzmittel, Weichmacher, sensitometrische Regler, Farbstoffe und farblose oder Farbpigmente.

Als Wasserstoffdonatoren werden in der Hauptsache aliphatische Polyether verwendet. Gegebenenfalls kann diese Funktion auch vom Bindemittel oder von dem polymerisierbaren Monomeren übernommen werden, wenn diese labile Wasserstoffatome besitzen.

Als Verbindungen zur Verminderung der Sauerstoffempfindlichkeit können mit Vorteil die in der DE-A 2 944 866 beschriebenen Disulfide zugesetzt werden.

Die Herstellung der lichtempfindlichen Materialien unter Verwendung des erfindungsgemässen Gemischs erfolgt in bekannter Weise. Das Gemisch wird in einem Lösungsmittel aufgenommen und die Lösung bzw. Dispersion durch Giessen, Sprühen, Tauchen oder Antragen mit Walzen auf den vorgesehenen Träger als Film aufgebracht und anschliessend getrocknet.

Die Art des Schichtträgers richtet sich nach dem Verwendungszweck des lichtempfindlichen Materials.

Neben Kupfer, Stahl, verchromtem Kupfer oder Stahl, Zink, Nickel, Aluminium und Aluminiumlegierungen können auch thermisch gewachsene oder abgeschiedene Siliciumdioxidschichten oder dotierte Oxidschichten, Kunststoffolien (Polyethylenterephthalat, Celluloseacetat) oder Siebdruckträger (Perlongaze, Nickelsiebe) verwendet werden.

Das erfindungsgemässe Gemisch ergibt photopolymerisierbare Schichten mit hoher Lichtempfindlichkeit. Die Schichten zeigen keine Klebe- oder Verprägungsneigung auch bei Schichtdicken bis zu 150 µm. Sie können mit wässrig-alkalischen Lösungen entwickelt werden und zeigen eine ausgezeichnete Entwicklerresistenz. Das Verhältnis von Schichtdicke der photopolymerisierbaren Schicht zur Auflösung liegt bei 1:1 bis 1:2. Die Flanken der belichteten Schichtteile und damit auch der Metallaufbau sind bei Schichtdicken bis zu 110 µm nahezu gerade und senkrecht.

Die Bebilderung der Kopiermaterialien erfolgt in bekannter Weise, z.B. durch Kontaktbelichtung unter einer Transparentvorlage. Dabei werden die üblichen Lichtquellen, wie Kohlenbogenlampen, Xenonlampen, mit Metallhalogeniden dotierte Quecksilberhochdrucklampen und dgl. verwendet. Die Bebilderung kann auch mit Laserlicht erfolgen, z.B. mit einem Argon-Ionen-Laser.

Die Entwicklung der belichteten Kopiermaterialien erfolgt in bekannter Weise durch Auswaschen der unbelichteten Schichtbereiche mit einem Entwickler. Geeignete Entwickler sind wässrige Lösungen, die Puffersalze, z.B. Ammonium- oder Alkaliphosphate, -silikate, -hydroxide oder -carbonate; Netzmittel, Farbstoffe, ggf. mit Wasser mischbare organische Lösungsmittel und andere übliche Zusätze enthalten können, sowie wässrige Lösungen von Netzmitteln.

Die erfindungsgemässen Gemische eignen sich für die Herstellung von Trockenresistfolien, Reliefbildern, Siebdruckschablonen und Farbprüffolien. Sie sind auch brauchbar als schnellhärtende Überzugsmassen, Zahnfüllmassen, Klebstoffe und zur Herstellung harter, thermostabiler Formkörper.

Mit besonderem Vorteil werden die Gemische in gelöster Form zur Herstellung von Ätz- bzw. Galvanoschutzschichten auf metallischen Trägern verwendet. Vor allem sind sie zur Anwendung auf Trägern aus Kupfer geeignet, wie sie z.B. zur Herstellung von kopierten Schaltungen und Tiefdruckformen verwendet werden. Sie lassen sich auch als vorgefertigte Trockenresistfolien mit Vorteil für die gleichen Anwendungen einsetzen.

Die ausgezeichnete Haftung der belichteten Schichtteile bewährt sich bei diesen Anwendungsformen nicht nur während der Entwicklung, sondern auch während einer nachfolgenden Ätzung und galvanischen Verstärkung des Trägers, bei der die Schichten eine gute Resistenz zeigen.

Das erfindungsgemässe Gemisch zeichnet sich bei Verwendung der als Zusatz bevorzugten Urethanmonomeren der Formel II durch eine besonders geringe Empfindlichkeit gegenüber Sauerstoff aus, die auch bei dünnen Schichten noch ausgeprägt ist. Die Schichten sind nach dem Trocknen der Lösung nicht klebrig und werden auch im Vakuumkontakt durch die Vorlage nicht verprägt. Es ist überraschend, dass diese Eigenschaft nur durch die oben beschriebenen Polypropylenglykolester der Formel I erreicht wird. Bei Ersatz dieser Monomeren durch die gleiche oder die äquivalente Menge Polyethylenglykolbisacrylat oder -methacrylat wird eine klebrige Schicht erhalten.

Das Gemisch kann in Schichtdicken von etwa 0,5 bis 150 µm aufgebracht werden. Es zeigt auch in dieser Dicke eine hohe Lichtempfindlichkeit und ist trotzdem schnell mit alkalischen Lösungen entwickelbar bei guter Entwicklerresistenz. Es ist deshalb für die Herstellung von Galvanoschablonen einsetzbar. Die Flanken der belichteten Schichtteile und damit auch der Metallaufbau sind bei Schichtdicken bis zu 110 µm nahezu gerade und senkrecht.

In manchen Fällen kann es vorteilhaft sein, die Schicht vor dem Ätzen durch Einbrennen noch widerstandsfähiger zu machen.

Die folgenden Beispiele erläutern Ausführungsformen des erfindungsgemässen Gemischs und deren Verwendung zur Herstellung von photopolymerisierbaren Kopiermaterialien. Prozentangaben und Mengenverhältnisse sind, wenn nichts anderes angegeben ist, in Gewichtseinheiten zu verstehen. Die Zahlenangaben bei Polyglykolen bedeuten deren Molekulargewichte.

Beispiel 1

Eine Lösung von

66 Gt eines Terpolymerisats aus n-Hexylmethacrylat, Methacrylsäure und Styrol (60:30:10) mit einem mittleren Molekulargewicht von ca. 35 000 und einer Säurezahl um 200,
42 Gt Polypropylenglykol-420-dimethacrylat,
1,3 Gt 9-Phenyl-acridin und
0,2 Gt eines blauen Farbstoffs, erhalten durch Kuppeln von 2,4-Dinitro-6-chlor-benzoldiazoniumsalz mit 2-Methoxy-5-acetylamino-N-cyanoethyl-N-hydroxyethyl-anilin, in
240 Gt Butanon und
30 Gt Ethanol

wurde auf eine mit 25 µm dicker Kupferfolie kaschierte Phenopast-Schichtstoffplatte so aufgeschleudert, dass nach dem Trocknen bei 100°C eine Schichtdicke von 80 µm erhalten wurde. Die Platte wurde mittels einer 5-kW-Metallhalogenidlampe im Abstand von 110 cm zwischen Lampe und Vakuumkopierrahmen 6 Sekunden belichtet. Als Vorlage diente sowohl ein 13stufiger Belichtungskeil mit Dichteinkrementen von 0,15 als auch eine Strichvorlage mit Linienbreiten und Abständen bis herab zu 80 µm.

Nach der Belichtung wurde die Schicht mit 0,8%iger Natriumcarbonatlösung in einem Sprühentwicklungsgerät 100 Sekunden lang entwickelt. Es wurden fünf bis sechs vollvernetzte Keilstufen erhalten.

Die Platte wurde dann 30 Sekunden mit Leitungswasser gespült, 30 Sekunden in einer 15%igen Ammoniumperoxidisulfat-Lösung angeätzt, erneut mit Wasser gespült, 30 Sekunden in 10%ige Schwefelsäure getaucht und sodann nacheinander in den folgenden Elektrolytbädern galvanisiert:

1. 50 Minuten in einem Kupferelektrolytbad der Firma Schlötter, Geislingen/Steige, Typ «Glanzkupfer-Bad PC»
Stromdichte: 2,5 A/dm²
Metallaufbau: ca. 25 µm
Temperatur: Raumtemperatur
2. 55 Minuten in einem Bleizinnbad LA der Firma Schlötter, Geislingen/Steige
Stromdichte: 2 A/dm²
Metallaufbau: 55 µm
Temperatur: Raumtemperatur

Die Platte zeigte keinerlei Unterwanderungen oder Beschädigungen.

Der Überhang bzw. die Neigung einer Flanke der Resistschicht betrug 7 µm bei einer Resistbahnbreite von 138 µm, d.h. die Oberkante der Resistflanke ragte um 7 µm über die Unterkante hinaus.

Die Platte konnte sodann in 5%iger KOH-Lösung bei 50°C entschichtet und das freigelegte Kupfer in den üblichen Ätzmedien weggeätzt werden.

Ersetzt man das Monomere durch das Dimethacrylat von Polyethylenglykol 400, durch Trimethylolethantriacrylat oder ein Umsetzungsprodukt aus 1 Mol 2,2,4-Trimethylhexamethylendiisocyanat und 2 Mol Hydroxyethylmethacrylat, so erhält man Schichten, von denen die Filmvorlage nach dem Belichten nur unter Beschädigung der Resistschicht durch Herausreissen von Schichtteilen entfernt werden kann.

Beispiel 2

Wie in Beispiel 1 wurde eine kupferkaschierte Isolierstoffplatte beschichtet, getrocknet, belichtet und entwickelt. Die Platte wurde dann wie folgt galvanisiert:

1. 100 Minuten in dem in Beispiel 1 angegebenen Kupferelektrolytbad
Stromdichte: 2,5 A/dm²
Metallaufbau: ca. 50 µm
Temperatur: Raumtemperatur
2. 10 Minuten in einem Nickelbad der Firma Schlötter, Geislingen/Steige, Typ «Norma»

Stromdichte: 4 A/dm²
Metallaufbau: ca. 10 µm
Temperatur: 50°C

3. 12 Minuten in einem Goldbad der Firma Blasberg, Solingen, Typ «Autronex CC»
Stromdichte: 1 A/dm²
Metallaufbau: ca. 5 µm
Temperatur: 40°C

Auch diese Platte zeigte keine Unterwanderungen oder Beschädigungen.

Beispiel 3

Die in Beispiel 1 beschriebene Resistlösung wurde auf eine mit 35 µm starker Kupferfolie kaschierte Phenoplast-Schichtstoffplatte aufgeschleudert und getrocknet (Schichtdicke 108 µm). Die Platte wurde 8 Sekunden belichtet und dann 140 Sekunden mit 0,8%iger Natriumcarbonat-Lösung entwickelt. Es wurden 6 vollvernetzte Keilstufen erhalten.

Nach der in Beispiel 1 beschriebenen Vorbehandlung wurde die Platte wie folgt galvanisiert:

180 Minuten in dem in Beispiel 2 angegebenen Nickelbad
Stromdichte: 4 A/dm²
Metallaufbau: 180 µm
Temperatur: 50°C

Auch diese Platte zeigte keinerlei Unterwanderungen oder Beschädigungen und liess sich mit KOH-Lösung entschichten und mit üblichen Ätzmitteln ätzen.

Es wurde ein Überhang der einseitigen Resistflanke von 13 µm bei einer Resistbahnbreite von 138 µm ermittelt.

Beispiel 4

100 ml der Photoresistlösung aus Beispiel 1 wurden mit 25 ml Butanon und 25 ml Ethylenglykolmonoethylether verdünnt.

Mit Hilfe einer Mettenheimer Zylindersprühanlage wurde eine Resistschicht auf 10 µm dick vorvernickeltes 0,2 mm starkes Messingblech aufgebracht. Die Resistschicht wurde sofort nach dem Aufbringen 10 Minuten lang mit einem Infrarotstrahler (1200 W) mit 20 cm Abstand zur Schicht getrocknet. Die Schichtdicke betrug 70 µm. Es wurde 50 Sekunden mit einer 400-W-Lampe belichtet und dann mit 0,8%iger Natriumcarbonat-Lösung entwickelt. Die Entwicklungszeit betrug 80 Sekunden, die Resistenzzeit 7 Minuten. Die Auflösung lag bei etwa 65 µm.

Die Versuchsplatte wurde 3 Minuten in 2%iger Kaliumbichromatlösung passiviert und nach einer Wasserspülung (30 Sekunden) bei 3 A/dm² 2 Stunden bzw. 3 Stunden vernickelt. Dabei wurden 70 µm bzw. 110 µm Nickel abgeschieden.

Die Nickel-Galvanoschablone wurde entfernt und die Resistschablone anschliessend mit Aceton abgelöst.

Beispiel 5

Auf einen mit 17 µm dicker Kupferfolie kaschierten Phenoplast-Schichtstoffträger wurde eine Lösung folgender Zusammensetzung so aufgeschleudert, dass nach dem Trocknen eine Schichtdicke von 5 µm erhalten wurde:

| | | |
|---|---|---|
| 6,5 | Gt | des in Beispiel 1 angegebenen Mischpolymerisats, |
| 3,4 | Gt | Polypropylenglykol-420-dimethacrylat, |
| 0,3 | Gt | 9-Phenyl-acridin, |
| 0,075 | Gt | des blauen Farbstoffs aus Beispiel 1 und |
| 0,025 | Gt | Kristallviolett in |
| 26 | Gt | Butanon und |
| 20 | Gt | Ethanol |

Die Platte wurde 20 Sekunden mit einer 5 kW-Metallhalogenidlampe belichtet. Als Vorlage diente sowohl ein Tiefdruckraster (Stegbreite 36 µm) als auch eine Itek-Testvorlage (Elemente von 2–500 µm). Es wurde 35 Sekunden mit 0,8%iger Natriumcarbonat-Lösung entwickelt.

Die Auflösung nach dem Entwickeln lag bei etwa 10 µm, die Stegbreite des Tiefdruckrasters betrug 48 µm.

Nach dem Ätzen mit Eisen-III-chlorid-Lösung bei 40°C (65 Sekunden) wurden Raster-Stegbreiten von 12 µm, gemessen an der Oberkante, und 33 µm an der Unterkante erhalten.

Beispiele 6–13

Es wurden Lösungen wie in Beispiel 5 bereitet, die an Stelle der dort eingesetzten Menge Polypropylenglykol-420-dimethacrylat (PPG-420-DMA) Mischungen dieses Dimethacrylats mit anderen di- bzw. polyfunktionellen Methacrylaten oder Acrylaten enthielten.

| Beispiel Nr. | PPG-420-DMA (Gt) | Zusatzmonomeres (Gt) | Klebrigkeit [1)] | Optimale Belicht. Zeit (sec) | Auflösung (µm) bei einer Schichtdicke von 5 µm |
|---|---|---|---|---|---|
| 6 | 2,55 | Dipropylenglykoldimethacrylat (0,85) | ++ | 25 | 12 |
| 7 | 2,55 | Polypropylenglykol-420-diacrylat (0,85) | + | 20 | 10 |

| Beispiel Nr. | PPG-420-DMA (Gt) | Zusatzmonomeres (Gt) | Klebrigkeit [1] | Optimale Belicht. Zeit (sec) | Auflösung (μm) bei einer Schichtdicke von 5 μm |
|---|---|---|---|---|---|
| 8 | 2,55 | Diurethan aus 2 Mol Glycerindimethacrylat und 1 Mol Hexamethylendiisocyanat (0,85) | ++ | 15 | 10 |
| 9 | 1,7 | Obiges Diurethan (1,7) | ++ | 15 | 12 |
| 10 | 2,55 | Oligourethan aus 2 Mol Glycerindimethacrylat, 2 Mol Hexamethylendiisocyanat und 1 Mol Polyethylenglykol 400 (0,85) | ++ | 15 | 10 |
| 11 | 1,7 | obiges Oligourethan (1,7) | ++ | 15 | 10 |
| 12 | 2,55 | Polyethylenglykol-400-dimethacrylat (PEG-400-DMA) (0,85) | ++ | 25 | 10 |
| 13 | 1,7 | PEG-400-DMA (1,7) | + | 13 | 10 |

[1] ++ völlig trockene, klebefreie Schicht;
+ leichte Verprägungen

Beispiel 14

Eine Lösung von

| | | |
|---|---|---|
| 6,5 | Gt | des in Beispiel 1 angegebenen Terpolymerisats, |
| 1,6 | Gt | Polyethylenglykol-400-dimethacrylat, |
| 1,6 | Gt | Polypropylenglykol-420-dimethacrylat, |
| 0,1 | Gt | 9-Phenylacridin, |
| 0,01 | Gt | des Azofarbstoffs aus Beispiel 1, |
| 0,0045 | Gt | des Azofarbstoffs 5-Nitro-2-[2-methyl-4-(N-ethyl-N-cyanoethyl)-amino-benzolazo-]benzthiazol, |
| 0,8 | Gt | des unten beschriebenen Elastomeren in |
| 38 | Gt | Butanon |

wurde auf eine biaxial verstreckte und thermofixierte Polyethylenterephthalatfolie der Stärke 25 μm so aufgeschleudert, dass nach dem Trocknen bei 100°C ein Schichtgewicht von 40 g/m² erhalten wurde.

Die so hergestellte Trockenresistfolie wurde mit einer handelsüblichen Laminiervorrichtung bei 120°C auf eine vorgewärmte, mit 35 μm starker Kupferfolie kaschierte Phenoplast-Schichtstoffplatte laminiert und 4 Sekunden mit einem handelsüblichen Belichtungsgerät belichtet. Als Vorlage diente eine Strichvorlage mit Linienbreiten und Abständen bis herab zu 80 μm.

Nach der Belichtung wurde die Polyesterfolie abgezogen und die Schicht mit 0,8%iger Natriumcarbonatlösung in einem Sprühentwicklungsgerät 90 Sekunden lang entwickelt.

Die Platte wurde dann, wie in Beispiel 1 beschrieben, weiter behandelt und galvanisiert, jedoch wurde in dem Bleizinnbad 20 Minuten bei 1 A/dm² behandelt, und der erhaltene Metallaufbau betrug 10 μm.

Die Platte zeigte keinerlei Unterwanderungen oder Beschädigungen. Die Farbe des Resists war unverändert. Die Platte konnte dann in 5%iger KOH-Lösung bei 50°C entschichtet und das freigelegte Kupfer in den üblichen Ätzmedien weggeätzt werden.

Eine Resistschicht, die anstelle des oben angegebenen Monomerengemischs 3,2 Gt Polyethylenglykol-400-dimethacrylat enthielt, zeigte nach der Bleizinn-Galvanik, insbesondere in Bädern mit hohem Fluoroborsäuregehalt (300 g/l), eine deutliche Goldverfärbung, verbunden mit einer gewissen Versprödung.

Das verwendete Elastomere wurde wie folgt hergestellt:

A. In einem 1-Liter-Vierhalskolben, ausgerüstet mit Rührer, Thermometer, Rückflusskühler und Trockenrohr, wurden 426 Gt Glycidylmethacrylat und 216 Gt Adipinsäure durch Rühren vermischt und nach Zugabe von 19,7 Gt p-Methoxyphenol und 6,4 Gt Benzyl-triethylammoniumchlorid vorsichtig auf eine Innentemperatur von 80°C erhitzt. Nach ca. 2 Stunden wurde eine klare Lösung erhalten, die noch 14 Stunden bei 80°C gehalten wurde. Der Gehalt an freiem Glycidylmethacrylat war nach dieser Zeit kleiner als 0,5%.

B. In einen mit Rührer, Thermometer, Tropftrichter, Kühler und Trockenrohr bestückten 1-Liter-Vierhalskolben wurden 143 Gt eines oligomeren Diisocyanats aus Tolylendiisocyanat und Poly-1,4-butandiol mit einem mittleren Molekulargewicht um 2000 und einem Isocyanatgruppengehalt von 4,1 Gew.% (Adiprene L 100), gelöst in 300 Vt Methylethylketon, gegeben und mit 0,87 Gt Benzochinon und 0,85 Vt einer Lösung versetzt, die durch Lösen von 6,3 Gt Eisen-III-acetylacetonat und 0,45 Gt Triethylamin in Methylethylketon und Auffüllen mit Methylethylketon auf 100 Vt hergestellt wurde. In den Tropftrichter wurde eine Lösung von 31,33 Gt des nach A erhaltenen Umsetzungsproduktes in 300 Vt Methylethylketon gefüllt und der auf 70°C erhitzten und gerührten Lösung im Kolben innerhalb 40 Minuten zugetropft. Nach zweistündigem Nachrühren bei 30°C wurden dem klaren Reaktionsgemisch 10 Vt Ethanol zugesetzt. Durch Abdestillieren des Lösemittels wurde aus der viskosen Lösung eine nichtklebende kautschukartige Masse erhalten, die in zahlreichen organischen Lösungsmitteln, wie Tetrahydrofuran, Aceton oder Toluol klar löslich war. Die reduzierte spezifische Viskosität des Produkts betrug 0,72 dl/g (gemessen an einer 1%igen Lösung in Dimethylformamid bei 25°C).

## Patentansprüche

1. Durch Strahlung polymerisierbares Gemisch, das als wesentliche Bestandteile

a) 20 bis 80 Gew.% eines wasserunlöslichen, in wässrig-alkalischen Lösungen löslichen Mischpolymerisats von Methylmethacrylat und Methacrylsäure oder von Methacrylsäure, Alkylmethacrylaten und Methylmethacrylat, Styrol oder Acrylnitril,

b) 0,1 bis 20 Gew.% eines durch Strahlung aktivierbaren Polymerisationsinitiators und

c) 20 bis 80 Gew.% eines Acryl- oder Methacrylsäureesters eines 2- bis 4wertigen Alkohols enthält, wobei 10 bis 100 Gew.%, bezogen auf die Gesamtmenge an polymerisierbaren Verbindungen, aus einem Polyglykoldiacrylat oder -dimethacrylat bestehen, dadurch gekennzeichnet, dass das Polyglykoldiacrylat bzw. -dimethacrylat eine Verbindung der Formel I

$$CH_2=\overset{R}{\overset{|}{C}}-CO(O-CH_2-\overset{CH_3}{\overset{|}{C}H})_nOOC-\overset{R}{\overset{|}{C}}=CH_2 \qquad (I)$$

ist, worin

R ein Wasserstoffatom oder eine Methylgruppe und

n eine Zahl von 4 bis 10 ist.

2. Polymerisierbares Gemisch nach Anspruch 1, dadurch gekennzeichnet, dass es eine Verbindung der Formel I enthält, in der R eine Methylgruppe ist.

3. Durch Strahlung polymerisierbares Kopiermaterial mit einem Schichtträger und einer polymerisierbaren Schicht, die als wesentliche Bestandteile:

a) 20 bis 80 Gew.% eines wasserunlöslichen, in wässrig-alkalischen Lösungen löslichen Mischpolymerisats von Methylmethacrylat und Methacrylsäure oder von Methacrylsäure, Alkylmethacrylaten und Methylmethacrylat, Styrol oder Acrylnitril,

b) 0,1 bis 20 Gew.% eines durch Strahlung aktivierbaren Polymerisationsinitiators und

c) 20 bis 80 Gew.% eines Acryl- oder Methacrylsäureesters eines 2- bis 4wertigen Alkohols enthält, wobei 10 bis 100 Gew.%, bezogen auf die Gesamtmenge an polymerisierbaren Verbindungen, aus einem Polyglykoldiacrylat oder -dimethacrylat bestehen, dadurch gekennzeichnet, dass das Polyglykoldiacrylat bzw. -dimethacrylat eine Verbindung der Formel I

$$CH_2=\overset{R}{\overset{|}{C}}-CO(O-CH_2-\overset{CH_3}{\overset{|}{C}H})_nOOC-\overset{R}{\overset{|}{C}}=CH_2 \qquad (I)$$

ist, worin

R ein Waserstoffatom oder eine Methylgruppe und

n eine Zahl von 4 bis 10 ist.

4. Polymerisierbares Kopiermaterial nach Anspruch 3, dadurch gekennzeichnet, dass die polymerisierbare Schicht eine Dicke von 0,5 bis 150 µm hat.

## Revendications

1. Mélange polymérisable par radiation, qui contient comme constituants essentiels:

a) de 20 à 80% en poids d'un copolymère insoluble dans l'eau, soluble dans les solutions alcalines aqueuses, de méthacrylate de méthyle et d'acide méthacrylique ou d'acide méthacrylique, de méthacrylates d'alcoyle et de méthacrylate de méthyle, de styrène ou de nitrile acrylique,

b) de 0,1 à 20% en poids d'un initiateur de polymérisation activable par radiation, et

c) de 20 à 80% en poids d'un acrylate ou d'un méthacrylate d'un alcool ayant de 2 à 4 fonctions alcool, de 10 à 100% en poids, par rapport à la quantité totale de composés polymérisables, étant constitué d'un diacrylate ou diméthacrylate de polyglycol, caractérisé en ce que le diacrylate ou diméthacrylate de polyglycol est un composé de formule I

$$CH_2=\overset{R}{\overset{|}{C}}-CO(O-CH_2-\overset{CH_3}{\overset{|}{C}H})_nOOC-\overset{R}{\overset{|}{C}}=CH_2 \qquad (I)$$

dans laquelle R est un atome d'hydrogène ou un groupe méthyle et n est un nombre de 4 à 10.

2. Mélange polymérisable selon la revendication 1, caractérisé en ce qu'il contient un composé de formule I, dans lequel R est un groupe méthyle.

3. Matériau de reproduction polymérisable par radiation, avec un support de couche et une

couche polymérisable qui contient comme constituants essentiels:

a) de 20 à 80% en poids d'un copolymère insoluble dans l'eau, soluble dans les solutions alcalines aqueuses, de méthacrylate de méthyle et d'acide méthacrylique ou d'acide méthacrylique, de méthacrylates d'alcoyle et de méthacrylate de méthyle, de styrène ou de nitrile acrylique,

b) de 0,1 à 20% en poids d'un initiateur de polymérisation activable par radiation, et

c) de 20 à 80% en poids d'un acrylate ou d'un méthacrylate d'un alcool ayant de 2 à 4 fonctions alcool, de 10 à 100% en poids, par rapport à la quantité totale de composés polymérisables, étant constitués d'un diacrylate ou diméthacrylate de polyglycol, caractérisé en ce que le diacrylate ou diméthacrylate de polyglycol est un composé de formule I

$$CH_2=\overset{R}{\overset{|}{C}}-CO(O-CH_2-\overset{CH_3}{\overset{|}{C}}H)_nOO\overset{R}{\overset{|}{C}}-C=CH_2 \qquad (I)$$

dans laquelle

R est un atome d'hydrogène ou un groupe méthyle, et

n est un nombre de 4 à 10.

4. Matériau de reproduction polymérisable selon la revendication 3, caractérisé en ce que la couche polymérisable a une épaisseur de 0,5 à 150 µm.

**Claims**

1. A mixture which can be polymerized by radiation and which contains, as the essential constituents,

a) 20 to 80% by weight of a copolymer of methyl methacrylate and methacrylic acid or of methacrylic acid, alkyl methacrylates and methyl methacrylate, styrene or acrylonitril which copolymer is insoluble in water, but soluble in aqueous alkaline solutions,

b) 0,1 to 20% by weight of a polymerization initiator which can be activated by radiation and

c) 20 to 80% by weight of an acrylate or methacrylate of a di- to tetrahydric alcohol, wherein 10 to 100% by weight, based on the total amount of polymerizable compounds, consist of a polyglycol diacrylate or dimethacrylate, characterized in that the polyglycol diacrylate or dimethacrylate is a compound of the formula I

$$CH_2=\overset{R}{\overset{|}{C}}-CO(O-CH_2-\overset{CH_3}{\overset{|}{C}}H)_nOO\overset{R}{\overset{|}{C}}-C=CH_2 \qquad (I)$$

in which R is a hydrogen atom or a methyl group and n is a number from 4 to 10.

2. A polymerizable mixture as claimed in Claim 1, which contains a compound of the formula I in which R is a methyl group.

3. A copying material which can be polymerized by radiation and has a support and a polymerizable layer which contains, as the essential constituents,

a) 20 to 80% by weight of a copolymer of methyl methacrylate and methacrylic acid or of methacrylic acid, alkyl methacrylates and methyl methacrylate, styrene or acrylonitril which copolymer is insoluble in water, but soluble in aqueous alkaline solutions,

b) 0,1 to 20% by weight of a polymerization initiator which can be activated by radiation and

c) 20 to 80% by weight of an acrylate or methacrylate of a di- to tetrahydric alcohol, wherein 10 to 100% by weight, based on the total amount of polymerizable compounds, consist of a polyglycol diacrylate or dimethacrylate, characterized in that the polyglycol diacrylate or dimethacrylate is a compound of the formula I

$$CH_2=\overset{R}{\overset{|}{C}}-CO(O-CH_2-\overset{CH_3}{\overset{|}{C}}H)_nOO\overset{R}{\overset{|}{C}}-C=CH_2 \qquad (I)$$

in which R is a hydrogen atom or a methyl group and n is a number from 4 to 10.

4. A polymerizable copying material as claimed in Claim 3, wherein the polymerizable layer has a thickness of 0.5 to 150 µm.